Europäisches Patentamt

(19) European Patent Office

Office européen des brevets

(11) Veröffentlichungsnummer: **0 019 621**
**B1**

(12) **EUROPÄISCHE PATENTSCHRIFT**

(45) Veröffentlichungstag der Patentschrift: **03.04.85**

(21) Anmeldenummer: **79901005.3**

(22) Anmeldetag: **05.09.79**

(86) Internationale Anmeldenummer:
**PCT/CH79/00119**

(87) Internationale Veröffentlichungsnummer:
**WO 80/01206 12.06.80 Gazette 80/13**

(51) Int. Cl.4: **G 01 R 21/00, H 03 M 1/86**

(54) **VERFAHREN ZUR MESSUNG ELEKTRISCHER LEISTUNG.**

(30) Priorität: **01.12.78 CH 12300/78**

(43) Veröffentlichungstag der Anmeldung:
**10.12.80 Patentblatt 80/25**

(45) Bekanntmachung des Hinweises auf die
Patenterteilung:
**03.04.85 Patentblatt 85/14**

(84) Benannte Vertragsstaaten:
**CH DE FR GB NL SE**

(56) Entgegenhaltungen:
**EP-A-0 011 094**
**DE-A-2 710 712**

**Alta Fequenza, Band 26, Nr. 11, veröffentlicht im November 1966, (Mailand), G. Sacedoti et al. "A standard digital energy mater for measurements in single-phase circuits and of active and reactive energy in symmetrical three-phase circuits", Seiten 889-890**

**Die Akte enthält technische Angaben, die nach dem Eingang der Anmeldung eingereicht wurden und die nicht in dieser Patentschrift enthalten sind.**

(73) Patentinhaber: **LGZ LANDIS & GYR ZUG AG Konzern-Patentabteilung CH-6301 Zug (CH)**

(72) Erfinder: **STEINLE, Benedikt Schönbühl 10 6300 Zug (CH)**
Erfinder: **SCHNEIDER, Gernot Arbach 55a 6340 Baar (CH)**
Erfinder: **NUENLIST, Hans Rigistrasse 45 6314 Unterägeri (CH)**

(74) Vertreter: **Müller, Hans-Jürgen, Dipl.-Ing. Müller, Schupfner & Gauger Lucile-Grahn-Strasse 38 Postfach 80 13 69 D-8000 München 80 (DE)**

Courier Press, Leamington Spa, England.

## Beschreibung

In der am 28.5.1980 veröffentlichten EP—A—0 011 094 ist eine dem Oberbegriff des Anspruchs 2 entsprechende Messeinrichtung beschrieben, bei welcher in jeder Periode des Referenzsignals jeweils ein digitaler Messwert für die Spannung und ein digitaler Messwert für den Strom ermittelt werden. Es wird ein der Spannung proportionales Messignal $u(t)$ mit einem periodisch variierenden, dreieckförmigen Referenzsignal $U_1$ mit gleichlangen Dreieckschenkeln verglichen und eine Impulsfolge $S_{1u}$ gebildet, die jeweils an dem dem Schnittpunkt $P_1$ bzw. $P_2$ der beiden Signale $u(t)$ und $U_1$ entsprechenden Zeitpunkt ihren logischen Zustand wechselt. Die Impulsdauer $T_1$, d.h. die zwischen den genannten Schnittpunkten liegende Zeitdifferenz ist ein Mass für den Mittelwert

$$\bar{U}_1 = \frac{\bar{u}_1 + \bar{u}_2}{2}$$

des Messignals $u(t)$ in der Periode des Referenzsignals $U_r(t)$, wobei $\bar{u}_1$ bzw. $\bar{u}_2$ den Momentanwert des Messignals $u_1$ im Schnittpunkt $P_1$ bzw. $P_2$ bedeutet. Mit Taktimpulsen hoher Frequenz wird die Impulsfolge $S_{1u}$ abgetastet, und in einen Impulszähler wird eine der Impulsdauer $T_1$ entsprechende Anzahl Impulse eingezählt. Diese Anzahl Impulse stellt einen digitalen Messwert für den Mittelwert $\bar{U}_1$ der Spannung dar und wird in einem Rechenglied mit einem auf ähnliche Weise ermittelten digitalen Mittelwert des Stromes multipliziert. Dadurch erhält man ein Mass für die elektrische Leistung und durch Integration ein Mass für die elektrische Energie.

Infolge der endlichen Frequenz des Referenzsignals $U_1$ ergibt sich ein prinzipbedingter Messfehler, wenn das Messignal $u(t)$ keine konstante oder keine sinusförmige Größe tiefer Frequenz ist. Beispielsweise werden bei der Messung der elektrischen Leistung in einem Wechselstromnetz gegebenenfalls vorhandene Oberwellen nicht richtig erfaßt. Der Messfehler kann zwar in annehmbaren Grenzen gehalten werden, wenn die Frequenz des Referenzsignals $U_1$ genügend hoch gewählt wird; beispielsweise ergibt eine Verdoppelung dieser Frequenz eine Viertelung des Messfehlers. Infolge der endlichen Arbeitsgeschwindigkeit gewisser Bauteile, beispielsweise des Komparators, kann jedoch die Frequenz des Referenzsignals nicht beliebig hoch gewählt werden.

Ferner ist ein Verfahren nach dem Oberbegriff des Anspruchs 1 bekannt (Alta Frequenza, Vol 35, No. 11, Nov. 1966, S.889—898), bei dem als Referenzsignal ein Sägezahnsignal verwendet und in jeder Periode des Sägezahnsignals ein digitaler Messwert für die Spannung sowie ein digitaler Messwert für den Strom ermittelt werden.

Schließlich ist es bekannt (DE—A—2 710 712), Spannung und Strom mittels eines einzigen stochastischen Codierers abzutasten und das digitale Signal zur Kompensation von Abtastzeitfehlern zu interpolieren.

Der Erfindung liegt die Aufgabe zugrunde, bei einem Verfahren der im Oberbegriff der Ansprüche 1 und 2 angegebenen Art den Messfehler zu verkleinern, ohne hierzu die Frequenz des Referenzsignals zu erhöhen.

Die Lösung dieser Aufgabe gelingt durch die in den Kennzeichen der Ansprüche 1 und 2 angegebenen Merkmale.

Mit den Verfahren nach der Erfindung wird die Häufigkeit der Ermittlungen und der Multiplikationen der Messwerte verdoppelt, wodurch sich eine Viertelung des Messfehlers ergibt.

Nachfolgend wird die Erfindung am Beispiel eines statischen Elektrizitätszählers zur Messung elektrischer Energie in einem Wechselstromnetz näher erläutert.

Es zeigen:

Fig. 1 ein Blockschaltbild eines statischen Elektrizitätszählers,

Fig. 2 ein Spannungs-Zeit-Diagramm,

Fig. 3 ein Blockschaltbild einer Variante des statischen Elektrizitätszählers und

Fig. 4 und 5 weitere Spannungs-Zeit-Diagramme.

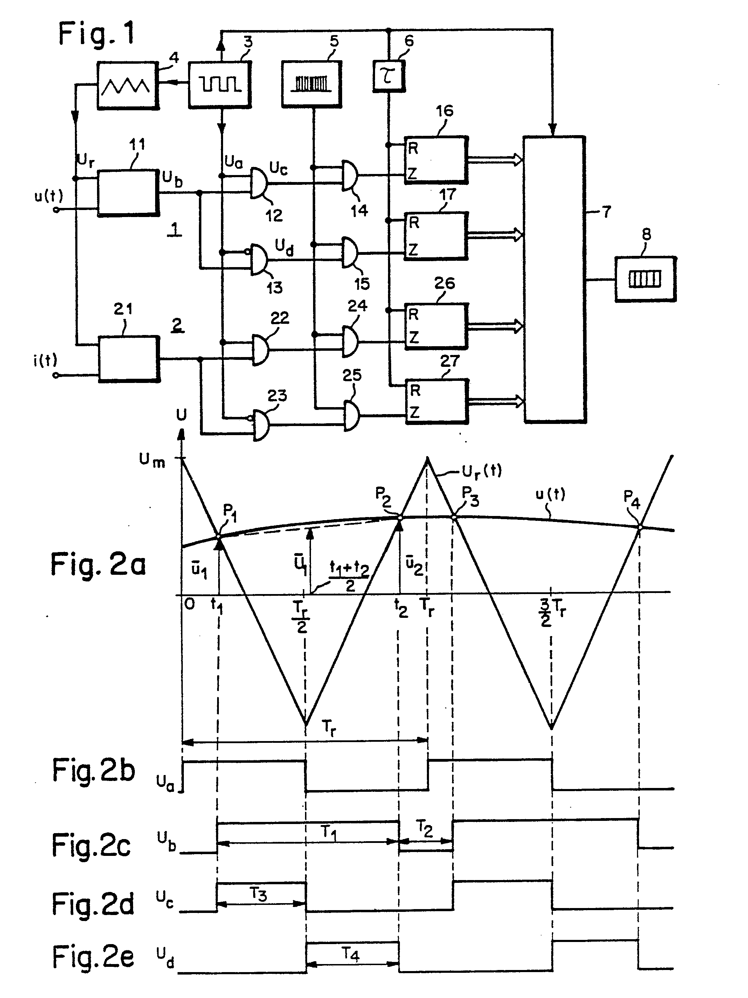

In der oberen Hälte der Fig. 1 ist ein Spannungsmeßkanal 1 und in der unteren Hälfte ein Strommeßkanal 2 dargestellt. Ein Rechteckgenerator 3, ein von diesem gesteuerter Referenzsignalgenerator 4, ein Abtastgenerator 5 und ein Verzögerungsglied 6 sind beiden Meßkanälen 1, 2 gemeinsam zugeordnet. Der Spannungsmeßkanal 1 besteht aus einem Komparator 11, vier UND-Toren 12 bis 15 und zwei Impulszählern, 16, 17, und der Strommeßkanal 2 aus einem Komparator 21, vier UND-Toren 22 bis 25 und zwei Impulszählern 26, 27.

Ein der zu messenden Spannung proportionales elektrisches Signal $u(t)$ ist an den ersten Eingang des Komparators 11 und ein dem zu messenden Strom proportionales elektrisches Signal $i(t)$ an den ersten Eingang des Komparators 21 angelegt. Der Ausgang des Referenzsignalgenerators 4 ist jeweils mit dem zweiten Eingang der Komparatoren 11, 21 verbunden.

Der Ausgang des Komparators 11 ist über die UND-Tore 12 und 14 an den Zähleingang Z des Impulszählers 16 sowie über die UND-Tore 13 und 15 an den Zähleingang Z des Impulszählers 17 geschaltet. Entsprechend ist der Ausgang des Komparators 21 über die UND-Tore 22 und 24 mit dem Zähleingang Z des Impulszählers 26 sowie über die UND-Tore 23 und 25 mit dem Zähleingang Z des Impulszählers 27 verbunden. Der Ausgang des Rechteckgenerators 3 ist jeweils mit einem Eingang der UND-Tore 12 und 22, einem invertierenden Eingang der UND-Tore 13 und 23 sowie über das Verzögerungsglied 6 mit dem Rückstelleingang R der Impulszähler 16, 17, 26 und 27 verbunden. Der Abtastgenerator 5 ist jeweils an einen Eingang der UND-Tore 14, 15, 24 und 25 angeschlossen.

Von den Impulszählern 16, 17, 26 und 27 führt jeweils ein Datenbus zu einem Rechenglied 7, das vom Rechteckgenerator 3 vesteuert wird und durch einen Mikrocomputer gebildet sein kann. An das Rechenglied 7 ist ein Impulszähler 8 geschaltet.

Die beschriebene Anordnung arbeitet wie folgt:

Der Rechteckgenerator 3 erzeugt eine symmetrische Rechteckspannung $U_a$ mit der Periodendauer $T_r$ (Fig. 2b). Der vom Rechteckgenerator 3 gesteuerte Referenzsignalgenerator 4 gibt ein periodisch variierendes Referenzsignal $U_r(t)$ mit der Periodendauer $T_r$ ab, das einen dreieckformigen Verlauf hat wobie die Nullachse die Schenkel der Dreiecke halbliert und die Schenkel gleich lang sind. Der Komparator 11 vergleicht das Messignal $u(t)$ mit dem Referenzsignal $U_r(t)$. Die Fig. 2a zeigt einen beispielsweisen Verlauf des Messignals $u(t)$, welches das Referenzsignal $U_r(t)$ in den Punkten $P_1$ bis $P_4$ schneidet. In jedem dieser Schnittpunkte wechselt die vom Komparator 11 abgegebene Impulsfolge $U_b$ (Fig. 2c) ihren logischen Zustand. Der Komparator 11 arbeitet zusammen mit dem Referenzsignalgenerator 4 als sog. Mark-Space-Modulator, denn es gilt

$$\frac{T_1 - \dfrac{T_r}{2}}{T_r} = k \cdot \bar{U}_1$$

wobei $T_1$ die Impulsdauer der Impulsfolge $U_b$ und k eine Konstante bedeutet.

An Ausgang des UND-Tores 12 entsteht eine Impulsfolge $U_c$ (Fig. 2d) mit der Impulsdauer $T_3$ und am Ausgang des UND-Tores 13 eine Impulsfolge $U_d$ (Fig. 2e) mit der Impulsdauer $T_4$. Ein Impuls der Impulsfolge $U_c$ beginnt jeweils in der ersten Halbperiode des Referenzsignals $U_r(t)$ im Zeitpunkt $t_1$ des Schnittpunkts $P_1$ und endet am Ende der ersten Halbperiode im Wendezeitpunkt

$$\frac{T_r}{2}$$

des Referenzsignals. Zu Beginn der zweiten Halbperiode des Referenzsignals $U_r(t)$ beginnt jeweils ein Impuls der Impulsfolge $U_d$. Dieser Impuls endet im Zeitpunkt $t_2$ des Schnittpunkts $P_2$. Die Impulsdauer $T_3$ stellt einen analogen Messwert $\bar{u}_1$ für das Messignal $u(t)$ im Zeitpunkt $t_1$ und die Impulsdauer $T_4$ einen analogen Messwert $\bar{u}_2$ für das Messignal $u(t)$ im Zeitpunkt $t_2$ dar:

$$\bar{u}_1 = \frac{U_m}{T_r}(4\ T_3 - T_r) \qquad (1)$$

$$\bar{u}_2 = \frac{U_m}{T_r}(4\ T_4 - T_r) \qquad (2)$$

wobei $U_m$ den Scheitelwert des Referenzsignals $U_r(t)$ bedeutet.

Der Abtastgenerator 5 erzeugt schmale Abtastimpulse mit im Vergleich zur Periodendauer $T_r$. hoher Frequenz. Während der Impulsdauer $T_3$ lässt das UND-Tor 14 diese Abtastimpulse durch, so dass in den Impulszähler 16 eine zur Impulsdauer $T_3$ proportionale Anzahl Impulse eingezählt wird. Das UND-Tor 15 lässt die Abtastimpulse während der Impulsdauer $T_4$ durch und in den Impulszähler 17 wird eine zur Periodendauer $T_4$ proportionale Anzahl Impulse eingezählt.

Die vorstehenden Erläuterungen der Arbeitsweise des Spannungsmesskanals 1 gelten in analoger Weise auch für den Strommesskanal 2. In der ersten Halbperiode des Referenzsignals $U_r(t)$ werden Abtastimpulse in den Impulszähler 26 und in der zweiten Halbperiode Abtastimpulse in den Impulszähler 27 eingezählt, wobei die Anzahl der eingezählten Abtastimpulse jeweils einen digitalen Messwert für den Strom darstellt. Am Ende der Periode $T_r$ wird der Inhalt der Impulszähler 16, 17, 26 und 27 in das Rechenglied 7 übertragen. In diesem wird einerseits der Inhalt des Impulszählers 16 (bzw. eine aus diesem Inhalt gemäss Gleichung (1) abgeleitete Messgrösse) mit dem Inhalt des Impulszählers 26 und andererseits der Inhalt des Impulszählers 17 mit jenem des Impulszählers 27 multipliziert. Jedes der so gebildeten Produkte ist ein Mass für den Momentanwert der Leistung. Durch einen Impuls am Rückstelleingang R werden die Impulszähler 16, 17, 26 und 27 wieder zurückgestellt.

In jeder Periode des Referenzsignals $U_r(t)$ wiederholt sich der geschilderte Vorgang von neuem. Aus den fortlaufend anfallenden Momentanwerten der Leistung wird im Rechenglied 7 bzw. im Impulszähler 8 durch Integration der Mittelwert der Leistung bzw. die elektrische Energie ermittelt.

Da in jeder Halbperiode des Referenzsignals $U_r(t)$ jeweils ein digitaler Messwert $\bar{u}_1$ bzw. $\bar{u}_2$ für die Spannung und ein digitaler Messwert für den Strom ermittelt werden und das Produkt der beiden Messwerte gebildet wird, ergibt sich gegenüber der Methode, in jeder Periode jeweils nur den Mittelwert $\bar{U}_1$ der Spannung mit einem entsprechenden Mittelwert des Stromes zu multiplizieren, eine Verdoppelung der Häufigkeit der Messwert- und Produktbildung und damit eine Viertelung des Messfehlers.

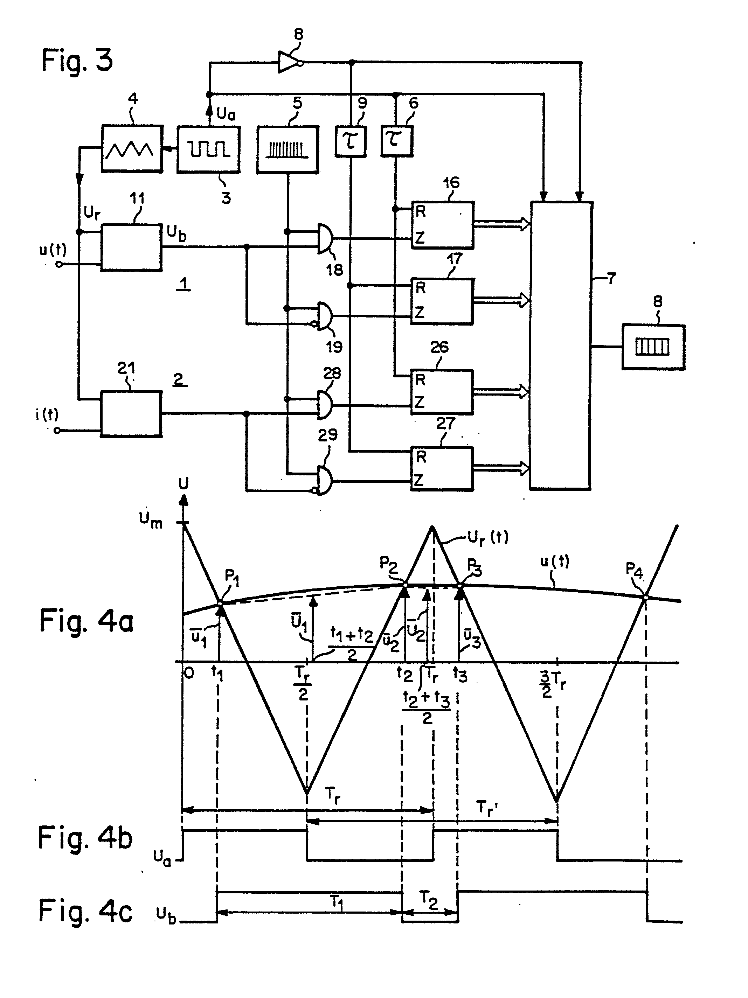

In der Fig. 3 weisen gleiche Bezugszeichen wie in der Fig. 1 auf gleiche Teile hin. Der Ausgang des Komparators 11 ist mit einem Eingang eines UND-Tores 18 sowie mit einem invertierenden Eingang eines UND-Tores 19 und der Ausgang des Komparators 21 mit einem Eingang eines UND-Tores 28 sowie mit einem invertierenden Eingang eines UND-Tores 29 verbunden. Der Abtastgenerator 5 ist an je einen zweiten Eingang der UND-Tore 18, 19, 28 und 29 angeschlossen. Jedes dieser UND-Tore ist ausgangsseitig mit dem Zähleingang Z des ihm zugeordneten Impulszählers 16, 17, 26 oder 27 verbunden. Der Ausgang des Rechteckgenerators 3 ist einerseits über das Verzögerungsglied 6 an die Rückstelleingänge R der Impulszähler 16 und 26 und andererseits über einen Inverter 8 und ein Verzögerungsglied 9 an die Rückstelleingänge R der Impulszähler 17 und 27 geschaltet. Ferner steuert der Rechteckgenerator 3 unmittelbar sowie über den Inverter 8 das Rechenglied 7.

Anhand der Fig. 4 wird im folgenden die Arbeitsweise der beschriebenen Anordnung erläutert. In der Periode $T_r$ des Referenzsignals $U_r(t)$ lässt das UND-Tor 18 während der Impulsdauer $T_1$ der Impulsfolge $U_b$ (Fig. 4c) die Abtastimpulse des Abtastgenerators 5 durch. In den Impulszähler 16 wird eine Anzahl Abtastimpulse eingezählt, die zur Impulsdauer $T_1$ proportional ist und gemäss der Gleichung

$$\bar{U}_1 = \frac{U_m}{T_r}(2\,T_1 - T_r) \qquad (3)$$

ein dem Mittelwert

$$\bar{U}_1 = \frac{\bar{u}_1 + \bar{u}_2}{2} \qquad (4)$$

des Messignals $u(t)$ entsprechenden digitalen Messwert darstellt. Auf analoge Weise wird in den Impulszähler 26 eine Anzahl Abtastimpulse eingezählt, die einen dem Mittelwert des Stromes entsprechenden digitalen Messwert darstellt. Am Ende der Periode $T_r$ werden der Inhalt des Impulszählers 16 und jener des Impulszählers 26 in das Rechenglied 7 übertragen, dort gemäss Gleichung (3) in einen zum Mittelwert $\bar{U}_1$ proportionalen Messwert umgeformt und miteinander multipliziert. Kurz danach werden die Impulszähler 16 und 26 zurückgestellt.

In einer Periode $T_r'$, die sich aus der zweiten Halbperiode und der nachfolgenden ersten Halbperiode des Referenzsignals $U_r(t)$ zusammensetzt, in der Fig. 4 also zur Zeit

$$\frac{T_r}{2}$$

beginnt und zur Zeit

$$\frac{3}{2}$$

$T_r$ endet, wird ein zweiter Mittelwert

$$\bar{U}_2 = \frac{\bar{u}_2 + \bar{u}_3}{2} \qquad (5)$$

gebildet. Dabei bedeutet $\bar{u}_3$ den Momentanwert des Messignals $u(t)$ im Zeitpunkt $t_3$, d.h. im ersten Schnittpunkt $P_3$ in der nächsten Periode $T_r$ des Referenzsignals $U_r(t)$.

In der Periode $T_r'$ lässt das UND-Tor 19 während der Pausendauer $T_2$ der Impulsfolge $U_b$, d.h. während der Zeitdifferenz $(t_3 - t_2)$, die Abtastimpulse durch. In den Impulszähler 17 wird eine Anzahl Abtastimpulse eingezählt, die zur Pausendauer $T_2$ proportional ist und gemäss der Formel

$$\bar{U}_2 = \frac{U_m}{T_r}(T_r - 2\,T_2) \qquad (6)$$

einen dem Mittelwert $\bar{U}_2$ des Messignals $u(t)$ entsprechenden digitalen Messwert darstellt. In den Impulszähler 27 wird in der Periode $T_r'$ auf analoge Weise eine Anzahl Abtastimpulse eingezählt, die ein Mass für den Mittelwert des Stromes in der Periode $T_r'$ darstellt.

Am Ende der Periode $T_r'$ werden die Impulszähler 17 und 27 abgefragt und kurz danach zurückgestellt. Im Rechenglied 7 werden die so ermittelten Messwerte gemäss Gleichung (6) um geformt und miteinander multipliziert.

Der geschilderte Vorgang wiederholt sich mit der Frequenz des Referenzsignals $U_r(t)$. Pro Periode $T_r$ werden also zwei Messwerte $\bar{U}_1$ und $\bar{U}_2$ für die Spannung ermittelt und mit entsprechenden Messwerten für den Strom multipliziert, so dass sich auch bei der Anordnung nach der Fig. 3 im Vergleich zum älteren Vorschlag et. EP—A—0 011 094 eine Verdoppelung der Häufigkeit der Ermittlung und der Multiplikation der Messwerte und damit eine Viertelung des Messfehlers ergibt.

Es versteht sich, dass die den Mittelwerten $\bar{U}_1$ und $\bar{U}_2$ der Messignale $u(t)$ und $i(t)$ entsprechenden digitalen Messwerte auch dadurch ermittelt werden können, dass diese nach den Gleichungen (4) und (5) aus den den Momentanwerten $\bar{u}_1$, $\bar{u}_2$ und $\bar{u}_3$ entsprechenden digitalen Messwerten berechnet werden. Das heisst mit anderen Worten, dass bei der Anordnung nach der Fig. 1 das Rechenglied 7 so betrieben wird, dass dieses die den Mittelwerten $\bar{U}_1$ und $\bar{U}_2$ entsprechenden digitalen Messwerte aus den Zählerständen der Impulszähler 16, 17, 26 und 27 berechnet.

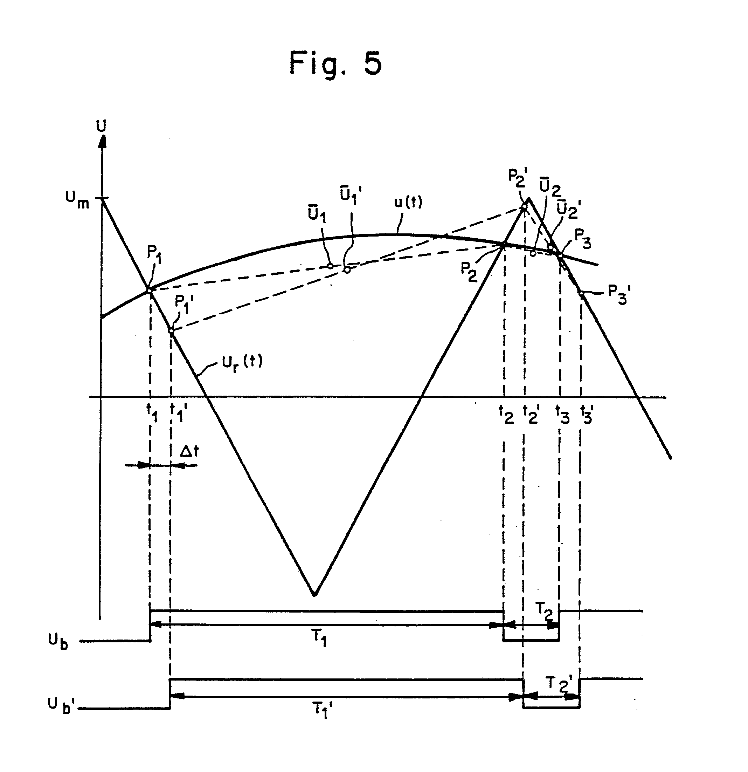

Es ist einleuchtend, dass in der Praxis die Schnittpunkte $P_1$, $P_2$, $P_3$, $P_4$ ... mit den Komparatoren 11, 21 nicht mit beliebiger Genauigkeit bestimmt werden könne. Infolge der endlichen Arbeitsgeschwindigkeit dieser Komparatoren tritt bei der Erfassung der Schnittpunkte eine unvermeidbare Zeitverzögerung auf, die von der Signalhöhe und der Steilheit der Messignale $u(t)$ und $i(t)$ abhängig sein kann. Anhand der Fig. 5 wird gezeigt, dass sich bei der beschriebenen Messung der Mittelwert $\bar{U}_1$ und $\bar{U}_2$ solche Zeitverzögerungen auf das Messresultat kaum auswirken. Nimmt man an, dass der Komparator 11 jeweils nicht in den Zeitpunkten $t_1$, $t_2$, $t_3$ ..., sondern erst in den um die Zeitverzögerung $\Delta t$ verzögerten Zeitpunkten $t_1' = t_1 + \Delta t$, $t_2' = t_2 + \Delta t$, $t_3' = t_3 + \Delta t$ ... umschaltet, so werden nicht die wahren Schnittpunkte $P_1$, $P_2$, $P_3$ ..., sondern die scheinbaren Schnittpunkte $P_1'$, $P_2'$, $P_3'$ ... erfasst. Am Ausgang des Komparators 11 erscheint nicht die gewünschte Impulsfolge $U_b$, sondern eine gegenüber dieser verzögerte Impulsfolge $U_b'$ mit der Impulsdauer $T_1'$ und der Pausendauer $T_2'$. Obwohl die scheinbaren Schnittpunkte $P_1'$, $P_2'$, $P_3'$ ... von den wahren Schnittpunkten $P_1$, $P_2$, $P_3$

... im gezeichneten Beispiel sehr stark abweichen, sind die tatsächlich erfassten Mittelwerte $\bar{U}_1'$ und $\bar{U}_2'$ den wahren Mittelwerten $\bar{U}_1$ und $\bar{U}_2$ annähernd gleich:

$$\bar{U}_1 = \frac{U_m}{T_r}(2\,T_1 - T_r) \approx \bar{U}_1' = \frac{U_m}{T_r}(2\,T_1' - T_r)$$

$$\bar{U}_2 = \frac{U_m}{T_r}(T_r - 2\,T_2) \approx \bar{U}_2' = \frac{U_m}{T_r}(T_r - 2\,T_2')$$

**Patentansprüche**

1. Verfahren zur Messung elektrischer Leistung, insbesondere zur Anwendung in einem statischen Elektrizitätszähler, wobei einerseits ein dem jeweiligen Momentanwert der Spannung proportionales erstes Meßsignal (u(t)) und andererseits ein dem jeweiligen Momentanwert des Stromes proportionales zweites Meßsignal (i(t)) jeweils in einem Komparator (11; 21) mit einem periodisch variierenden Referenzsignal ($U_r(t)$) verglichen wird, das einen dreieckförmigen Verlauf aufweist und bei dem die Nullachse die Schenkel der Dreiecke halbiert, und eine Impulsfolge ($U_b$) gebildet wird, deren Impulsdauer ($T_1$) einen analogen Meßwert für den jeweils aus zwei Vergleichen mit dem Referenzsignal ($U_r(t)$) gewonnenen Mittelwert der Spannung bzw. des Stromes darstellt, und wobei jeweils ein digitaler Meßwert für den Momentanwert des ersten Meßsignals (u(t)) im Schnittpunkt mit dem Referenzsignal ($U_r(t)$) sowie ein digitaler Meßwert für den Momentanwert des zweiten Meßsignals (i(t)) im Schnittpunkt mit dem Referenzsignal ($U_r(t)$) ermittelt werden, indem Taktimpulse in Abhängigkeit vom jeweiligen binären Wert der Impulsfolge ($U_b$) gezählt werden, und wobei ferner in einem Rechenglied (7) jeweils der so ermittelte digitale Meßwert für den Momentanwert des ersten Meßsignals (u(t)) und der so ermittelte digitaler Meßwert für den Momentanwert des zweiten Meßsignals (i(t)) miteinander multipliziert werden, dadurch gekennzeichnet, daß als Referenzsignal ($U_r(t)$) ein Signal verwendet wird, bei dem die Schenkel der Dreiecke gleich lang sind, daß sowohl in der ersten Halbperiode als auch in der zweiten Halbperiode des Referenzsignals ($U_r(t)$) je ein dem Momentanwert ($\bar{u}_1$; $\bar{u}_2$) des ersten Meßsignals (u(t)) im Schnittpunkt ($P_1$; $P_2$) mit dem Referenzsignal ($U_r(t)$) entsprechender digitaler Meßwert sowie je ein dem Momentanwert des zweiten Meßsignals (i(t)) im Schnittpunkt mit dem Referenzsignal ($U_r(t)$) entsprechender digitaler Meßwert ausgezählt werden und daß die digitalen Meßwerte in der ersten Halbperiode des Referenzsignals ($U_r(t)$) vom Umschaltzeitpunkt ($t_1$) der Impulsfolge ($U_b$) bis zum Wendezeitpunkt des Referenzsignals ($U_r(t)$) und in der zweiten Halbperiode des Referenzsignals ($U_r(t)$) vom Wendezeitpunkt des Referenzsignals ($U_r(t)$) bis zum nächsten Umschaltzeitpunkt ($t_2$) der Impulsfolge ($U_b$) ausgezählt werden.

2. Verfahren nach dem Oberbegriff des Anspruchs 1, bei dem anstelle des Momentanwertes des ersten bzw. des zweiten Meßsignals deren jeweilige Mittelwerte ausgezählt werden, dadurch gekennzeichnet, daß als Referenzsignal ($U_r(t)$) ein Signal verwendet wird, bei dem die Schenkel der Dreiecke gleich lang sind, und daß sowohl in der eine erste Halbperiode und eine nachfolgende zweite Halbperiode umfassenden Periode ($T_r$) des Referenzsignals ($U_r(t)$) als auch in der dieselbe zweite Halbperiode und die nachfolgende erste Halbperiode des Referenzsignals ($U_r(t)$) einschließenden Periode ($T_r'$) je ein dem Mittelwert ($\bar{U}_1$; $\bar{U}_2$) des ersten Meßsignals (u(t)) entsprechender digitaler Meßwert sowie je ein dem Mittelwert des zweiten Meßsignals (i(t)) entsprechender digitaler Meßwert ausgezählt werden und daß die digitalen Meßwerte in der die erste Halbperiode und die nachfolgende zweite Halbperiode umfassenden Periode ($T_r$) des Referenzsignals ($U_r(t)$) durch Zählung der Taktimpulse vom ersten Umschaltzeitpunkt ($t_1$) der Impulsfolge ($U_b$) bis zum zweiten Umschaltzeitpunkt ($t_2$) ermittelt werden und daß die digitalen Meßwerte in der dieselbe zweite Halbperiode und die nachfolgende erste Halbperiode des Referenzsignals ($U_r(t)$) einschließenden Periode ($T_r'$) durch Zählung der Taktimpulse vom zweiten Umschaltzeitpunkt ($t_2$) bis zum nächsten Umschaltzeitpunkt ($t_3$) der Impulsfolge ($U_b$) ermittelt werden.

**Revendications**

1. Procédé de mesure de la puissance électrique, en particulier pour application dans un compteur d'électricité statique, dans lequel un premier signal de mesure (u(t)) proportionnel à la valeur instantanée de la tension d'une part, et un second signal de mesure (i(t)) proportionnel à la valeur instantanée du courant d'autre part sont comparés chacun dans un comparateur (11; 21) à un signal de référence ($U_r(t)$) variant périodiquement, de forme triangulaire et dont l'axe de temps coupe les côtés des triangles par le milieu; une suite d'impulsions ($U_b$) est produit, dont la durée d'impulsion ($T_1$) représente une valeur de mesure analogique de la valeur moyenne de la tension ou du courant obtenue par deux comparaisons avec le signal de référence ($U_r(t)$); une valeur de mesure numérique de la valeur instantanée du premier signal (u(t)) et une valeur de mesure numérique de la valeur instantanée du second signal de mesure (i(t)) sont déterminées au point d'intersection avec le signal de référence ($U_r(t)$), par comptage d'impulsions d'horloge commandé par la valeur binaire instantanée de la suite d'impulsions ($U_b$); et la valeur de mesure ainsi déterminée de la valeur instantanée du premier signal de mesure (u(t)) et la valeur de mesure numérique ainsi déterminée de la valeur instantanée du second signal de mesure (i(t)) sont multipliées dans un élément de calcul (7), ledit procédé étant caractérisé en ce que le signal de référence ($U_r(t)$) utilisé est constitué par des triangles isocèles; une valeur de mesure numérique correspondant à la valeur instantanée ($\bar{u}_1$; $\bar{u}_2$) du premier signal de mesure (u(t)) au point d'intersection ($P_1$; $P_2$) avec le signal de référence ($U_r$(t)) et une valeur de mesure numérique correspondant à la valeur instantanée du second signal de mesure (i(t)) au point d'intersection avec le signal de référence ($U_r$(t)) sont comptées tant pendant la première que pendant la seconde alternance du signal de référence ($U_r$(t)); et en ce que les valeurs de mesure numériques sont comptées pendant la première alternance du signal de référence ($U_r$(t)), de l'instant de commutation ($t_1$) de la suite d'impulsions ($U_b$) jusqu'à l'instant d'inversion du signal de référence ($U_r$(t)), et pendant la seconde alternance du signal de référence ($U_r$(t)), de l'instant d'inversion de ce dernier jusqu'au point de commutation suivant ($t_2$) de la suite d'impulsions ($U_b$).

2. Procédé selon le préambule de la revendication 1, dans lequel les valeurs moyennes du premier et du second signal de mesure sont comptées à la place de leurs valeurs instantanées, ledit procédé étant caractérisé en ce que le signal de référence ($U_r$(t)) utilisé est un signal dont les côtés des triangles sont égaux; en ce qu'une valeur de mesure numérique, correspondant à la valeur moyenne ($\bar{U}_1$; $\bar{U}_2$) du premier signal mesuré (u(t)) et une valeur de mesure numérique correspondant à la valeur moyenne du second signal mesuré (i(t)) sont comptées pendant une période ($T_r$) du signal de référence ($U_r$(t)), constituée par une première alternance, puis une seconde alternance, et pendant une période ($T'_r$) constituée par la même seconde alternance et la première alternance suivante du signal de référence ($U_r$(t)); en ce que les valeurs de mesure numériques sont déterminées pendant la période ($T_r$) du signal de référence ($U_r$(t)), constituée par la première alternance et la seconde alternance suivante, par comptage des impulsions d'horloge entre le premier ($t_1$) et le second instant de commutation ($t_2$) de la suite d'impulsions ($U_b$); et en ce que les valeurs de mesure numériques sont déterminées pendant la période ($T'_r$) constituée par ladite seconde alternance et la première alternance suivante du signal de référence ($U_r$(t)), par comptage des impulsions d'horloge entre le second ($t_2$) et l'instant de commutation suivant ($t_3$) de la suite d'impulsions ($U_b$).

**Claims**

1. A process for measuring electrical power, in particular for use in a static electricity meter, wherein on the one hand a first measuring signal (u(t)) which is proportional to the respective instantaneous value of the voltage and on the other hand a second measuring signal (i(t)) which is proportional to the respective instantaneous value of the current are each compared in a comparator (11; 21) to a periodically varying reference signal ($U_r$(t)) which is of a triangular form, and wherein the zero axis bisects the limbs of the triangle, and a pulse series ($U_b$) is formed, the pulse duration ($T_i$) of which represents an analogue measuring value for the mean value of the voltage and the current respectively, said mean value being respectively obtained from two comparisons with the reference signal ($U_r$(t)), and wherein a digital measuring value for the instantaneous value of the first measuring signal (u(t)) at the point of intersection with the reference signal ($U_r$(t)) and a digital measuring value for the instantaneous value of the second measuring signal (i(t)) at the point of intersection with the reference signal ($U_r$(t)) are respectively established, by clock pulses being counted in dependence on the respective binary value of the pulse series ($U_b$), and wherein moreover in a computing member (7), the digital measuring value established in that way, for the instantaneous value of the first measuring signal (u(t)) and the digital measuring value established in that way, for the instantaneous value of the second measuring signal (i(t)) are respectively multiplied together, characterised in that the reference signal ($U_r$(t)) is a signal wherein the limbs of the triangle are of equal length, that both in the first half-period and in the second half-period of the reference signal ($U_r$(t)), a digital measuring value corresponding to the instantaneous value ($\bar{u}_1$; $\bar{u}_2$) of the first measuring signal (u(t)) at the point of intersection ($P_1$; $P_2$) with the reference signal ($U_r$(t)) and a digital measuring value corresponding to the instantaneous value of the second measuring signal (i(t)) at the point of intersection with the reference signal are respectively counted out and that the digital measuring values are counted out in the first half-period of the reference signal ($U_r$(t)) from the switch-over time ($t_1$) of the pulse series ($U_b$) to the turning point of the reference signal ($U_r$(t)) and in the second half-period of the reference signal from the turning point of the reference signal ($U_r$(t)) to the next switch-over time ($t_2$) of the pulse series ($U_b$).

2. A process according to the classifying portion of claim 1 wherein, instead of the instantaneous value of the first and the second measuring signals respectively, the respective mean values thereof are counted out, characterised in that the reference signal ($U_r$(t)) is a signal wherein the limbs of the triangle are of equal length and that both in the period ($T_r$) of the reference signal ($U_r$(t)) which encompasses a first half-period and a subsequent second half-period, and in the period ($T_r'$) which includes the same second half-period and the subsequent first half-period of the reference signal, a digital measuring value corresponding to the mean value ($\bar{U}_1$; $\bar{U}_2$) of the first measuring signal (u(t)) and a digital measuring value corresponding to the mean value of the second measuring signal (i(t)) are respectively counted out and that the digital measuring values in the period ($T_r$) of the reference signal ($U_r$(t)) which encompasses the first half-period and the subsequent second half-period are established by counting the clock pulses from the first switch-over time ($t_1$) of the pulse series ($U_b$) to the second switch-over time

($t_2$) and that the digital measuring values in the period ($T_r'$) which includes the same second half-period and the subsequent first half-period of the reference signal ($U_r(t)$) are established by counting the clock pulses from the second switch-over time ($t_2$) to the next switch-over time ($T_3$) of the pulse series ($U_b$).

Fig. 1

Fig. 2a

Fig. 2b

Fig. 2c

Fig. 2d

Fig. 2e

Fig. 3

Fig. 4a

Fig. 4b

Fig. 4c

0 019 621

2

# Fig. 5